# EUROPEAN PATENT APPLICATION

(11) **EP 1 705 258 A2**
(43) Date of publication of application: **27.09.2006**
(21) Application number: 06000798.6
(22) Date of filing: 28.05.2001
(51) Int. Cl.: C22C 12/00, B23K 35/26

(54) **Composition, methods and devices for high temperature lead-free solder**

(62) Divisional of application: 01948248.8
(71) Applicant: Honeywell International, Inc., Morristown, New Jersey 07962 (US)
(72) Inventor: Lalena, John, 101 Columbia Road Morristown NJ 07962 (US); Dean, Nancy, 101 Columbia Road Morristown NJ 07962 (US); Weiser, Martin, 101 Columbia Road Morristown NJ 07962 (US)
(74) Representative: Hucker, Charlotte Jane

(57) **Abstract**

A lead-free solder (130) comprises an alloy that includes Ag in an amount of 2 wt % to 18 wt %, Bi in an amount of 98 wt % to 82 wt %, and a third element in an amount of 0.1 wt % to 5.0 wt %. The third element is selected from the group consisting of Au, Cu, Pt, Sb, Zn, In, Sn, Ni and Ge. Contemplated alloys have a solidus of no lower than 230°C and a liquidus of no higher than 400°C.

## Description

### Field of The Invention

The field of the invention is lead-free solders.

### Background of The Invention

Numerous known die attach methods employ a high-lead solder to attach the semiconductor die within an integrated circuit to a leadframe for mechanical connection and to provide thermal and electrical conductivity between the die and leadframe. Although most high-lead solders are relatively inexpensive and exhibit various desirable physico-chemical properties, the use of lead in die attach and other solders has come under increased scrutiny from an environmental and occupational health perspective. Consequently, various approaches have been undertaken to replace lead-containing solders with lead-free die attach compositions.

For example, in one approach polymeric adhesives (e.g., epoxy resins or cyanate ester resins) are employed to attach a die to a substrate as described in U.S. Pat. Nos. 5,150,195, 5,195,299, 5,250,600, 5,399,907, and 5,386,000. Polymeric adhesives typically cure within a relatively short time at temperatures generally below 200°C, and may even retain structural flexibility after curing to allow die attach of integrated circuits onto flexible substrates as shown in U.S. Pat. No. 5,612,403. However, many polymeric adhesives tend to produce resin bleed, potentially leading to undesirable reduction of electrical contact of the die with the substrate, or even partial or total detachment of the die.

To circumvent at least some of the problems with resin bleed, silicone-containing die attach adhesives may be employed as described in U.S. Pat. No. 5,982,041 to *Mitani et al.* While such adhesives tend to improve the bonding of the wire as well as that between the resin sealant and the semiconductor chip, substrate; package, and/or lead frame, the curing process for at least some of such adhesives requires a source of high-energy radiation, which may add significant cost to the die attach process.

Alternatively, a glass paste comprising a high-lead borosilicate glass may be employed as described in U.S. Pat. No. 4,459,166 to *Dietz* et al., thereby generally avoiding a high-energy curing step. However, many glass pastes comprising a high-lead borosilicate glass require temperatures of 425°C and higher to permanently bond the die to the substrate. Moreover, glass pastes frequently tend to crystallize during heating and cooling, thereby reducing the adhesive qualities of the bonding layer.

In yet another approach, various high melting solders are employed to attach a die to a substrate or leadframe. Soldering a die to a substrate has various advantages, including relatively simple processing, solvent-free application, and in some instances relatively low cost. There are various high melting solders known in the art. However, all or almost all of them have one or more disadvantages. For example, most gold eutectic alloys (e.g., Au-20%Sn, Au-3%Si, Au-12%Ge, and Au-25%Sb) are relatively costly and frequently suffer from less-than-ideal mechanical properties. Alternatively, Alloy J (Ag-10%Sb-65%Sn, see e.g., U.S. Pat. No. 4,170,472 to *Olsen et αl*.) maybe employed in various high melting solder applications. However, Alloy J has a solidus of 228°C and also suffers form relatively poor mechanical performance.

Although various methods and compositions for solders and die attach compositions are known in the art, all or almost all of them suffer from one or more disadvantages. Thus, there is still a need to provide improved compositions and methods for solders, and particularly for lead-free solders.

### Summary of the Invention

The present invention is directed to methods, compositions, and devices that include a solder comprising an alloy of Ag and Bi, with Ag present in an amount of 2wt% to 18wt% and Bi in an amount of 98wt% to 82wt%. Contemplated solders have a solidus of no lower than 262.5°C and a liquidus of no higher than 400°C.

In one aspect of the inventive subject matter, the silver in the alloy is present in an amount of 2wt% to 7wt% and the bismuth in an amount of 98wt% to 93wt%, or the silver in the alloy is present in an amount of 7wt% to 18wt% and the bismuth in an amount of 93wt% to 82wt%, or the silver in the alloy is present in an amount of5wt% to 9wt% and the bismuth in an amount of 95wt% to 91wt%. Contemplated compositions may further comprise a chemical element having an oxygen affinity that is higher than the oxygen affinity of the alloy, and preferred elements include AI, Ba, Ca, Ce, Cs, Hf, Li, Mg, Nd, P, Sc, Sr, Ti, Y, and Zr. The concentration of contemplated elements is typically in a range of between about 10 ppm and about 1000ppm.

In another aspect of the inventive subject matter, contemplated solders have a thermal conductivity of at least 9 W/m K, and exhibit a wetting force to wet Ag of approximately 0.2mN on a wetting balance after 1 second. Contemplated compositions may be formed into various shapes, including wires, ribbons, preforms, spheres, or ingots.

In a further aspect of the inventive subject matter, an electronic device comprises a semiconductor die that is coupled to a surface via contemplated compositions, wherein particularly contemplated semiconductor dies include silicon, germanium, and gallium arsenide dies. It is further contemplated that at least one of a portion of the die or a portion of the surface of such devices may be metallized with silver. In particularly preferred aspects, the surface comprises a silver-metallized leadframe. In further aspects, contemplated solders are utilized in an area array electronic package in form of a plurality of bumps on a semiconductor die to serve as electrical interconnects between the die and either a package substrate (generally known as flip chip) or a printed wiring board (generally known as chip on board). Alternatively, contemplated solders my be employed in the form of a plurality of solder balls to connect a package to a substrate (generally known as ball grid array with many variations on the theme) or to connect the die to either a substrate or printed wiring board.

In a still further aspect of the inventive subject matter, a method of manufacturing a solder composition has one step in which bismuth and silver are provided in an amount of 98wt% to 82wt% and 2wt% to 18wt%, respectively. In a further step, the silver and bismuth are melted at a temperature of at least 960°C to form an alloy having a solidus of no lower than 262.5°C and a liquidus of no higher than 400°C. Contemplated methods further include optional addition of a chemical element having an oxygen affinity that is higher than the oxygen affinity of the alloy.

Various objects, features, aspects and advantages of the present invention will become more apparent from the following detailed description of preferred embodiments of the invention along with the accompanying drawing.

### Brief Description of the Drawing

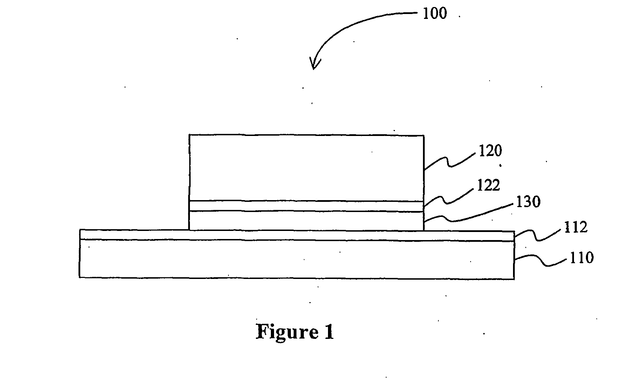

Figure 1 is a schematic vertical cross section of an exemplary electronic device.

### Detailed Description

The inventors have discovered that, among other desirable properties, contemplated compositions may advantageously be employed as near drop-in replacement for high-lead-containing solders in various die attach applications. In particular, contemplated compositions are lead-free alloys having a solidus of no lower than 260°C (and preferably no lower than 262.5°C) and a liquidus of no higher than 400°C.

In a particularly preferred aspect of the inventive subject matter, contemplated compositions are binary alloys that may be used as solder and that comprise silver in an amount of 2wt% to 18wt% and bismuth in an amount of 98wt% to 82wt%. In a preferred method of preparing contemplated compositions, a charge of appropriately weighed quantities *(supra)* of the pure metals, is heated under vacuum or an inert atmosphere (e.g., nitrogen or helium) to between 960°C-1000°C in a refractory or heat resistant vessel (e.g., a graphite crucible) until a liquid solution forms. The charge is stirred and allowed to remain at that temperature for an amount of time sufficient to ensure complete mixing and melting of both metals. The molten mixture, or melt, is then quickly poured into a mold, allowed to solidify by cooling to ambient temperature, and fabricated into wire by conventional extrusion techniques, which includes heating the billet to approximately 190°C, or into ribbon by a process in which a rectangular slab is first annealed at temperatures between 225-250°C and then hot-rolled at the same temperature. Alternatively, a ribbon may be extruded that can subsequently be rolled to thinner dimensions. The melting step may also be carried out under air so long as the slag that forms is removed before pouring the mixture into the mold.

In alternative aspects of the inventive subject matter, and especially where higher liquidus temperatures are desired, contemplated compositions may include Ag in the alloy in an amount of 7wt% to 18wt% and Bi in an amount of 93wt% to 82wt%. On the other hand, where relatively lower liquidus temperatures are desired, contemplated compositions may include Ag in the alloy in an amount of 2wt% to 7wt% and Bi in an amount of 98wt% to 93wt%. However, it is generally contemplated that most die attach applications may employ a composition in which Ag is present in the alloy in an amount of 5wt% to 10wt% and Bi in an amount of 95wt% to 90wt%.

It should be particularly appreciated that contemplated compositions may be employed as lead-free solders that are also completely devoid of Sn, which is a common predominant component in known lead-free solder. Moreover, while it is generally contemplated that particularly suitable compositions according to the inventive subject matter are binary alloys, it should also be appreciated that alternative compositions may include ternary, quaternary, and higher alloys.

For example, particularly suitable alternative compositions may include one or more chemical elements having an oxygen affinity that is higher than the oxygen affinity of the alloy (without the chemical element). Especially contemplated chemical elements include A1, Ba, Ca, Ce, Cs, Hf, Li, Mg, Nd, P, Sc, Sr, Ti, Y, and Zr, and it is further contemplated that such chemical elements may be present in the alloy at a concentration of between about 10 ppm and approximately 1000ppm. While not wishing to be bound to a particular theory or mechanism, it is contemplated that elements having a higher oxygen affinity than the alloy reduce metal oxides that are known to increase the surface tension of a melting or molten solder. Therefore, it is contemplated that a decrease in the amount of metal oxides during soldering will generally reduce the surface tension of the molten solder, and thereby significantly increase the wetting ability of the solder.

In a further example, one or more metals may be added to improve thermo-mechanical properties (e.g., thermal conductivity, coefficient of thermal expansion, hardness, pasty range, ductility, etc.) of the lead-free solder. Especially contemplated metals include Indium, Tin, Antimony, Zinc, and Nickel. However, various metals other than the aforementioned metals are also suitable for use in conjunction with the teachings presented herein, so long as such metals improve at least one thermo-mechanical property. Consequently, further contemplated metals include Copper, Gold, Germanium, and Arsenic. Especially contemplated alloys may therefore include Ag in an amount of 2wt% to 18wt%, Bi in an amount of 98wt% to 82wt%, and a third element in an amount of0.1wt% to 5.0wt%. Particularly contemplated third elements include at least one of Au, Cu, Pt, Sb, In, Sn, Ni, Ge, and/or Zn. Consequently, and depending on the particular amount of the third element, it should be recognized that such alloys will have a solidus of no lower than 230°C, more preferably no lower than 248°C, and most preferably no lower than 258°C and a liquidus of no higher than 400°C. Especially contemplated uses of such alloys includes die attach applications (e.g., attachment of a semiconductor die to a substrate). Consequently, it is contemplated that an electronic device will comprise a semiconductor die coupled to a surface via a material comprising the composition that includes contemplated ternary (of higher) alloys. With respect to the production of contemplated ternary alloys, the same considerations as outlined above apply. In general, it is contemplated that the third element is added in appropriate amounts to the binary alloy or binary alloy components.

It should further be appreciated that addition of chemical elements or metals to improve one or more physico-chemical or thermo-mechanical properties can be done in any order so long as all components in the alloy are substantially completely (*i*.*e*., at least 95% of each component) molten, and it is contemplated that the order of addition is not limiting to the inventive subject matter. Similarly, it should be appreciated that while it is preferred that silver and bismuth are combined prior to the melting step, it is also contemplated that the silver and bismuth may be melted separately, and that the molten silver and molten bismuth are subsequently combined. A further prolonged heating step to a temperature above the melting point of silver may be added to ensure substantially complete melting and mixing of the components. It should be particularly appreciated that when one or more additional elements are included, the solidus of contemplated alloys may decrease. Thus, contemplated alloys with such additional alloys may have a solidus in the range of 260-255°C, in the range of 255-250°C, in the range of 250-245°C, in the range of 245-235°C, and even lower.

With respect to thermal conductivity of contemplated alloys, it is contemplated that compositions according to the inventive subject matter have a conductivity of no less than 5 W/mK, more preferably of no less than 9 W/mK, and most preferably of no less than 15W/mK. It is further contemplated that suitable compositions include a solder having a wetting force to wet Ag of more than 0.1 mN, more preferably more than 0.2 mN, and most preferably more than 0.3 mN on a wetting balance after 1 second. It is still further contemplated that a particular shape of contemplated compositions is not critical to the inventive subject matter. However, it is preferred that contemplated compositions are formed into a wire shape, ribbon shape, or a spherical shape (solder bump).

Among various other uses, contemplated compounds *(e.g.,* in wire form) may be used to bond a first material to a second material. For example, contemplated compositions (and materials comprising contemplated compositions) may be utilized in an electronic device to bond a semiconductor die (e.g., silicon, germanium, or gallium arsenide die) to a leadframe as depicted in Figure 1. Here, the electronic device 100 comprises a leadframe 110 that is metallized with a silver layer 112. A second silver layer 122 is deposited on the semiconductor die 120 (e.g., by backside silver metallization). The die and the leadframe are coupled to each other via their respective silver layers by contemplated composition 130 (here, e.g., a solder comprising an alloy that includes Ag in an amount of 2wt% to 18wt% and Bi in an amount of 98wt% to 82wt%, wherein the alloy has a solidus of no lower than 262.5°C and a liquidus of no higher than 400°C). In an optimum die attach process, contemplated compositions are heated to about 40°C above the liquidus of the particular alloy for 15 seconds and preferably no higher than 430°C for no more than 30 seconds. The soldering can be carried out under a reducing atmosphere (e.g., hydrogen or forming gas).

In further alternative aspects, it is contemplated that the compounds according to the inventive subject matter may be employed in numerous soldering processes other than die attach applications. In fact, contemplated compositions may be particularly useful in all, or almost all step solder applications in which a subsequent soldering step is performed at a temperature below the melting temperature of contemplated compositions. Furthermore, contemplated compositions may also be employed as a solder in applications where high-lead solders need to be replaced with lead-free solders, and solidus temperatures of greater than about 260°C are desirable. Particularly preferred alternative uses include use of contemplated solders in joining components of a heat exchanger as a non-melting standoff sphere or electrical/thermal interconnection.

### Examples

Due to the differences in the coefficient of thermal expansion of various materials, solder joints will frequently experience shear loading. Therefore, it is especially desirable that alloys coupling such materials have a low shear modulus and, hence, good thermomechanical fatigue resistance. For example, in die attach applications low shear modulus and good themiomechanical fatigue help prevent cracking of a die, especially where relatively large dies are coupled to a solid support.

Based on the known elastic moduli of the pure metals, the fact that Ag and Bi exhibit partial solid miscibility, and the fact that the Ag-Bi system contains no intermetallic or intermediate phases, it is contemplated that the room temperature shear modulus of contemplated Ag-Bi alloys will be in the range of 13-16 GPa (assuming room temperature shear modulus to be an additive property - i.e., following the rule-of-mixtures). Room temperature shear moduli in the range of 13-16 GPa of contemplated alloys are especially favorable in comparison to 25 GPa for both Au-25%Sb and Au-20%Sn alloys (calculated by the same method and making the same assumption), and 21 GPa for Alloy J (Ag-10%Sb-65%Sn), with 22.3 GPa being a measured value for Alloy J.

Test assemblies constructed of a silicon die bonded to a leadframe with Ag-89%Bi alloy have shown no visible signs of failure after 1500 thermal aging cycles, which is in further support of the calculated and observed low shear modulus of contemplated Ag-Bi alloys.

In the test assemblies and various other die attach applications the solder is generally made as either a thin sheet that is placed between the die and the substrate to which it is to be soldered. Subsequent heating will melt the solder and form the joint. Alternatively the substrate can be heated followed by placing the solder on the heated substrate in thin sheet, wire, melted solder, or other form to create a droplet of solder where the semiconductor die is placed to form the joint.

For area array packaging contemplated solders can be placed as a sphere, small preform, paste made from solder powder, or other forms to create the plurality of solder joints generally used for this application. Alternatively, contemplated solders may be used in processes comprising plating from a plating bath, evaporation from solid or liquid form, printing from a nozzle like an ink jet printer, or sputtering to create an array of solder bumps used to create the joints.

In a preferred method, spheres are placed on pads on a package using either a flux or a solder paste (solder powder in a liquid vehicle) to hold the spheres in place until they are heated to bond to the package. The temperature may either be such that the solder spheres melt or the temperature may be below the melting point of the solder when a solder paste of a lower melting composition is used. The package with the attached solder balls is then aligned with an area array on the substrate using either a flux or solder paste and heated to form the joint.

A preferred method for attaching a semiconductor die to a package or printed wiring board includes creating solder bumps by printing a solder paste through a mask, evaporating the solder through a mask, or plating the solder on to an array of conductive pads. The bumps or columns created by such techniques can have either a homogeneous composition so that the entire bump or column melts when heated to form the joint or can be inhomogeneous in the direction perpendicular to the semiconductor die surface so that only a portion of the bump or column melts.

Thus, specific embodiments and applications of lead-free solders have been disclosed. It should be apparent, however, to those skilled in the art that many more modifications besides those already described are possible without departing from the inventive concepts herein. The inventive subject matter, therefore, is not to be restricted except in the spirit of the appended claims. Moreover, in interpreting both the specification and the claims, all terms should be interpreted in the broadest possible manner consistent with the context. In particular, the terms "comprises" and "comprising" should be interpreted as referring to elements, components, or steps in a non-exclusive manner, indicating that the referenced elements, components, or steps may be present, or utilized, or combined with other elements, components, or steps that are not expressly referenced.

## Claims

1. A composition comprising:
a solder comprising an alloy that includes Ag in an amount of 2wt% to 18wt%, Bi in an amount of 98 wt% to 82 wt%, and a third element in an amount of 0.1 wt% to 5.0wt%, wherein the third element is selected from the group consisting of Au, Cu, Pt, Sb, Zn, In, Sn, Ni and Ge, and wherein the alloy has a solidus of no lower than 230°C and a liquidus of no higher than 400 ° C.

2. The composition of claim 1, wherein the alloy has a solidus of no lower than 248 °C.

3. The composition of claim 1, wherein the alloy has a solidus of no lower than 258°C.

4. The composition of claim 1, wherein the third element is Au.

5. The composition of claim 1, wherein the third element is Cu.

6. The composition of claim 1, wherein the third element is Pt.

7. The composition of claim 1, wherein the third element is Sb.

8. The composition of claim 1, wherein the third element is Zn.

9. The composition of claim 1, wherein the third element is In.

10. The composition of claim 1, wherein the third element is Sn.

11. The composition of claim 1, wherein the third element is Ni.

12. The composition of claim 1, wherein the third element is Ge.

13. An electronic device comprising a semiconductor die coupled to a surface via a material comprising the composition as claimed in any one of the preceding claims.
